# EUROPÄISCHE PATENTSCHRIFT

(11) **EP 0 618 758 B1**
(45) Veröffentlichungstag und Bekanntmachung des Hinweises auf die Patenterteilung: **22.01.1997**
(21) Anmeldenummer: 93810235.7
(22) Anmeldetag: 02.04.1993
(51) Int. Cl.: H05K 7/14, G05B 19/02

(54) **Programmierbares Steuergeraet**
Programmable control unit
Unité de commande programmable

(43) Veröffentlichungstag der Anmeldung: 05.10.1994
(73) Patentinhaber: SAIA-Burgess Electronics AG, CH-3280 Murten (CH)
(72) Erfinder: Habegger, Peter, CH-3280 Murten (CH)
(74) Vertreter: AMMANN PATENTANWAELTE AG BERN

(56) Entgegenhaltungen:
- EP-A- 0 476 322
- US-A- 3 684 925
- US-A- 4 065 200

## Beschreibung

Die vorliegende Erfindung betrifft ein programmierbares Steuergerät mit in einem Gehäuse untergebrachten Printplatten. Solche Steuergeräte dienen der Programmsteuerung von Fertigungsmaschinen und -anlagen, Produktionsvorgängen und dergleichen. Bekannte Steuergeräte dieser Art weisen Metallgehäuse auf, in welchen die Printplatten fest eingebaut sind. Ein Austausch dieser Printplatten ist nicht möglich. Metallgehäuse bieten zwar an sich eine gute Abschirmung gegen Störfelder, sind aber teuer in der Herstellung. Im übrigen ist die Zugänglichkeit der Printplatten bei bekannten Geräte mangelhaft, d.h. es sind erhebliche Demontage- und Montagearbeiten erforderlich, um gewisse Printplatten auszutauschen oder zu ersetzen, und die Einbaumöglichkeit verschiedenartiger Printplatten ist beschränkt. Eine optimale Raumausnützung und somit eine kompakte Bauweise ist bei den bekannten Steuergeräten nicht gegeben.

Ein allgemeines Elektronikegrät mit den im Oberbegriff des Anspruchs 1 angegebenen Merkmalen ist aus US-A-3 684 925 bekannt.

Der vorliegenden Erfindung liegt die Aufgabe zugrunde, ein preisgünstiges, kompaktes Steuergerät zu schaffen, bei dem trotz des kompakten Aufbaus alle Teile leicht zugänglich sind. Zugleich wird eine vielseitige Ausbaubarkeit mit verschiedenartigen Printplatten angestrebt. Diese Aufgabe wird gemäss dem Kennzeichen des Anspruchs 1 gelöst.

Im Gehäuseunterteil sind Führungen vorgesehen, längs welchen auswechselbare Prinplatten verschiebbar und in Verschiebungsrichtung mit ihrer Steckverbindung steckbar angeordnet sind. Damit ist erreicht, dass auch diese unteren Printplatten sehr einfach ein- und ausgebaut werden können, indem sie schubladenartig unter eine oder mehrere obere Printplatten eingeschoben und mit einem Busprint verbunden werden können. Eine gute Zugänglichkeit der obenliegenden Printplatte oder Printplatten ist ohnehin gegeben. Es können dabei Printplatten unterschiedlicher Abmessungen in die erwähnten Führungen einschiebbar sein, oder aber es kann auch eine Gesamtprintplatte auf die Führungen montiert werden. Um trotz der Verwendung eines preisgünstigen einfachen Gehäuses aus Kunststoff eine genügende Abschirmung insbesondere der unteren Printplatten die als Peripheriemodule ausgebildet sein können zu erzielen, kann am Gehäuseboden ein Abschirmblech angebracht sein, das mit elastischen Fingern an Kontakten mindestens einer Printplatte anliegt und damit auf dem gewünschten Potential gehalten werden kann, um eine wirksame Abschirmung zu erzielen.

Weitere vorteilhafte Merkmale ergeben sich aus den abhängigen Ansprüchen und der folgenden Beschreibung eines Ausführungsbeispiels.
Fig. 1 zeigt eine Draufsicht auf das Gerät bei weggenommenem Deckel,
Fig. 2 zeigt einen Schnitt nach Linie II-II in Fig. 1 mit dem abgehobenen Gehäusedeckel und
Fig. 3 zeigt eine Draufsicht auf das Gerät bei weggenommenem Deckel und oberer Printplatte.

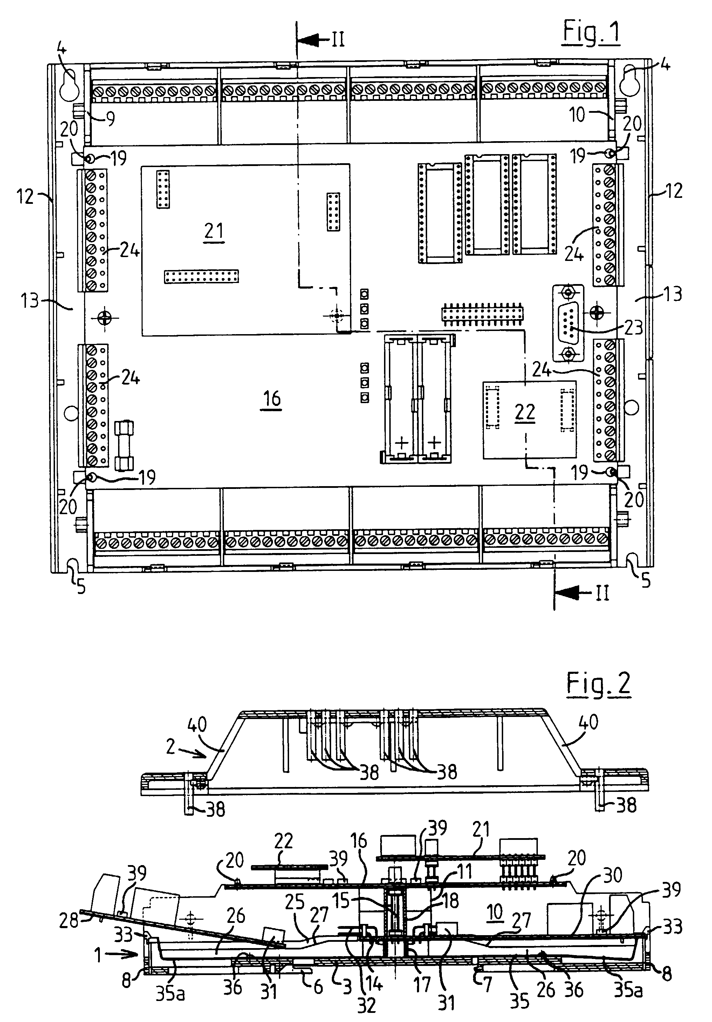

Das dargestellte Gerät weist ein Kunststoffgehäuse mit einem Unterteil 1 und einem Deckel 2 auf. Der Deckel kann in nicht näher dargestellter Weise auf den Unterteil aufgeschnappt werden oder aber es kann eine andere geeignete Verbindung, beispielsweise Schraubverbindng vorgesehen sein. Der Boden 3 des Unterteils ist mit Löchern 4 und Ausnehmungen 5 zur Montage auf einer flachen Unterlage sowie mit Haken 6 und 7 zur Montage auf einer Normschiene versehen. Zwei gegenüberliegende Seitenwände 8, die in Fig. 2 geschnitten dargestellt sind, sind relativ niedrig, so dass das Gehäuse auch bei aufgesetztem Deckel an diesen gegenüberliegenden Seiten offen und zugänglich bleibt. An den beiden anderen gegenüberliegenden Seiten befinden sich relativ hohe Seitenwände 9 und 10, die in der Mitte eine Lücke 11 zur Durchführung von Kabeln aufweisen. Die Seitenwände 9 und 10 bilden je zusammen mit einer etwas niedrigeren Aussenwand 12 einen seitlichen Kabelkanal. Durch diese Kabelkanäle können Kabel zu Anschlussklemmen über diesen Kanälen oder innerhalb der Seitenwände 9 und 10 geführt werden.

In der Mitte des Gehäuseunterteils ist zwischen den Lücken 11 der Seitenwände 9 und 10 ein langgestreckter, leistenartiger Busprint 14 angeordnet. Dieser Busprint steht über Steckerstifte 15 in Verbindung mit einer oberen Printplatte 16. Mittels Distanzhülsen 17 und 18 welche von einer beide Hülsen und die Printplatten 14 und 16 durchsetzenden und mit einem Auge am Boden 3 verschraubten Befestigungsschraube durchsetzt sind, werden die Printplatten 14 und 16 in der richtigen Position miteinander und mit dem Gehäuse verbunden. Die obere Printplatte 16 weist an allen vier Ecken Löcher 19 auf, in welche Bolzen 20 der Seitenwände 9 und 10 eingreifen und die obere Printplatte 16 orientieren.

Auf die obere Printplatte 16 können Zusatzmodule, beispielsweise ein Anzeigemodul 21 oder ein Modul 22 als serielle Schnittstelle aufgesteckt werden. Mit einem Stecker 23 der oberen Printplatte kann ein Programmiergerät verbunden werden. Im Deckel 2 können passende Oeffnungen bzw. Fenster vorgesehen sein, durch welche eine Steckverbindung zur Programmierung durchführbar ist, bzw. eine Anzeigeeinheit des Moduls 21 sichtbar ist. Die obere Printplatte 16, welche mit weiteren elektronischen Bauteilen bestückt ist, die in Fig. 1 teilweise schematisch angedeutet sind, wird üblicherweise als Hauptprint mit der Zentraleinheit CPU des Prozessors ausgeführt. Dieser Hauptprint ist mit seitlichen Klemmenleisten 24 versehen, mit welchen durch die Kanäle 13 zugeführte Kabel verbunden werden können.

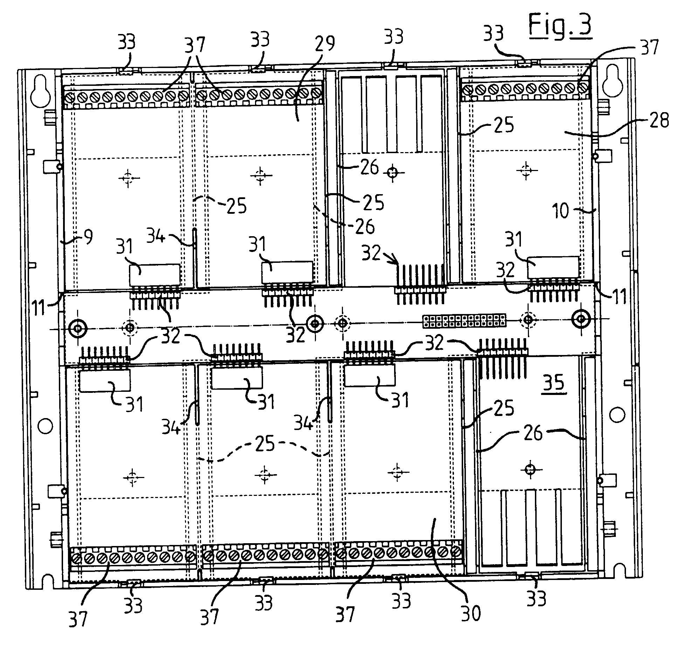

Am Boden des Gehäuseunterteils sind Führungen für einschiebbare Printplatten gebildet. Diese Führungen bestehen einerseits aus etwas höheren Trennrippen 25 (Fig. 2 und 3) welche je vier Einschubkammern auf jeder Seite gegeneinander abtrennen und je zwei innerhalb benachbarter Trennrippen 25 liegende, etwas niedrigere Stützrippen 26. Je die äussersten Führungskammern werden auf der einen Seite durch die Seitenwände 9 bzw. 10 begrenzt. Die Stützrippen 26 weisen eine geneigte Rampe 27 auf, welche einen inneren erhöhten Teil vor einem äusseren Teil geringerer Höhe der Stützrippe 26 verbindet. In die Führungskammern können untere Printplatten oder Module (28, 29 oder 30) von aussen unter die obere Printplatte 16 eingeschoben werden.

Fig. 2 zeigt auf der linken Seite wie eine dieser Printplatten eingeschoben wird. Jede Printplatte weist am Innenrand eine Steckbuchse 31 auf, welche mit einem entsprechenden Stecker 32 des Busprints 14 verbunden werden kann. Beim Einschieben einer Printplatte 28 wird die Vorderkante der etwas geneigt gehaltenen Printplatte durch die Stützrippen 26 vertikal geführt, und die Printplatte ist zwischen den Trennrippen 25 seitlich praktisch spielfrei geführt. Beim Einschieben der Printplatte wird somit die Steckbuchse 31 sicher in richtiger Position mit dem Stecker 32 verbunden. Dann wird der äussere Rand der vollständig eingeschobenen Printplatte unter einen Haltehaken 33 gedrückt, wie dies in Fig. 2 rechts für die volleingeschobene Printplatte 30 gezeigt ist. Es ist somit ein ausserordentlich einfaches Einsetzen bzw. Auswechseln von unteren Printplatten möglich, d.h. diese Printplatten sind zum Auswechseln oder Ersetzen leicht zugänglich und sowohl bei der Fabrikation als auch später trotz mangelnder Sicht zu den Verbindungsstellen leicht montierbar. Die unteren Printplatten 28, 29 und 30 sind mit Klemmenleisten 37 versehen, mit welchen Kabel verbunden werden können.

Wie Fig. 3 zeigt, können verschiedenartige Printplatten oder Module verwendet werden. Die Printplatte 28 hat eine Breite die derjenigen einer Führungskammer entspricht, der Modul 29 hat eine Breite von zwei Führungskammern und der Modul 30 hat eine Breite, die sich über drei Führungskammern erstreckt. Die Printplatten 29 und 30 weisen Schlitze 34 auf, in welche die erhöhten Innenteile der Trennrippen 25 eingreifen können. Es ist damit nicht nur die erwähnte leichte Zugänglichkeit, bzw. der leichte Zugriff zu allen vorhandenen Printplatten trotz der zwei- bis dreistöckigen kompakten Anordnung gegeben, sondern es ist auch möglich, in ein und dasselbe Gehäuse verschieden dimensionierte Printplatten ohne weiteres einzusetzen, um damit verschiedenen Anforderungen gerecht zu werden.

Am Boden des Gehäuseunterteils ist ein Abschirmblech 35 mittels thermisch verformter Haltebolzen 36 montiert. Wie in Fig. 3 an zwei Stellen dargestellt, weist das Abschirmblech 35 in jeder Führungskammer vier elastisch verformbare Zungen 35a auf, welche mit ihren äusseren Rändern an einen nicht dargestellten Kontakt der unteren Printplatten anliegt. Es ist damit eine sichere Verbindung zwischen den Printplatten und dem Abschirmblech 35 erzielt.

In den Gehäusedeckel 2 sind Lichtleiter 38 eingesetzt, welche bei montiertem Deckel mit ihren unteren Stirnseiten unmittelbar über Leuchtdioden 39 liegen. Einige Leuchtdioden sind auf der oberen Printplatte 16 und auf den unteren Printplatten in Fig. 2 angedeutet.

Der Gehäusedeckel ist dem Aufbau der elektronischen Komponenten des Gerätes entsprechend geformt, und zwar mit zwei flachen äusseren Randteilen und einem erhöhten Mittelteil. Zwischen diesen beiden Teilen sind geneigte Verbindungswände mit Lüftungsschlitzen 40 vorhanden. Damit ist eine gute Belüftung und Kühlung des Gerätes erzielt. Beide Gehäuseteile sind einfache Kunststoffteile die ohne aufwendige Werkzeuge hergestellt werden können.

## Patentansprüche

1. Programmierbares Steuergerät umfassend ein Kunststoffgehäuse mit einem Unterteil (1) und einem Deckel (2), der am Unterteil (1) lösbar befestigt ist, und
eine Mehrzahl von Printplatten (14, 16, 28, 29, 30), die in wenigstens zwei übereinander liegenden Ebenen im Unterteil (1) zugänglich angeordnet sind,
dadurch gekenzeichnet,
dass in einer oberen Ebene eine obere Printplatte als Hauptprint mit einer Zentraleinheit (CPU) (16) fix angeordnet ist,
dass in einer unteren Ebene eine Busprintplatte (14) fix angeordnet ist, die zwei Reihen von Steckern (32) trägt,
dass als Peripherie-Module ausgebildete auswechselbare Printplatten (28, 29, 30) mit den Steckern (32) zugeordneten Steckbuchsen (31) vorgesehen sind, die
zwischen die obere Printplatte (16) und den Boden (3) des Gehäuseunterteils (1) (3) so einschiebbar und mit der Busprintplatte (14) verbindbar sind, dass diese auswechselbaren Printplatten (28, 29, 30) alle in der unteren Ebene liegen, und
dass am Boden (3) des Gehäusunterteils (1) Führungen (25, 26, 27) angeordnet sind, längs welcher die auswechselbaren Printplatten (28, 29, 30) verschiebbar und in Verschiebungsrichtung mit ihren Steckbuchsen (31) steckbar sind.

2. Gerät nach Anspruch 1,
dadurch gekenzeichnet,
dass die auswechselbaren Printplatten (28, 29, 30) unterschiedliche Grössen aufweisen.

3. Gerät nach Anspruch 1,
dadurch gekennzeichnet,
dass am Gehäuseboden (3) ein Abschirmblech (35) angeordnet ist, das mit elastischen Fingern (35a) an Kontakten der auswechselbaren Printplatten (28, 29, 30) anliegt.

4. Gerät nach Anspruch 1,
dadurch gekennzeichnet,
dass der Gehäuseunterteil (1) an gegenübeliegenden Seiten Wände (9, 10, 12) aufweist, die seitliche Kabelkanäle (13) bilden.

5. Gerät nach Anspruch 4,
dadurch gekennzeichent,
dass zwei der Wände (9, 10) zugleich der Montage der oberen Printplatte (16) dienen.

6. Gerät nach Anspruch 1,
dadurch gekenzeichnet,
dass zusätzliche periphere Module (21,22), z.B. ein Anzeigemodul, vorgesehen sind, die auf die obere Printplatte (16) aufsteckbar sind.

7. Gerät nach Anspruch 1,
dadurch gekennzeichnet,
dass im Gehäusedeckel (2) Lichtleiter (38) angeordnet sind, die auf den Printplatten (16, 28, 29, 30) angeordneten Lichtquellen (39) anliegen.

8. Gerät nach Anspruch 7,
dadurch gekennzeichnet,
dass die Lichtquellen lichtemittierende Dioden (39) sind.

## Claims

1. Programmable control unit, comprising a housing of synthetic material having a lower part (1) and a cover (2) removably fastened to the lower part (1), and
a plurality of printed boards (14, 16, 28, 29, 30) being accessibly disposed within the lower part (1) in at least two planes lying one above the other,
characterised by the fact that
an upper printed board (16) is fixedly disposed in an upper plane as a main print carrying a central unit (CPU),
that a bus printed board (14) carrying two rows of male connectors (32) is fixedly disposed in a lower plane,
that exchangeable printed boards (28, 29, 30) arranged as peripheral modules are provided carrying female connectors (31) coordinated to the male connectors (32), said printed boards being arranged for insertion between the upper printed board (16) and the bottom (3) of the lower housing part (1) and for connection with the bus printed board (14) in such a manner that these exchangeable printed boards (28, 29, 30) are all situated in the lower plane, and
that guide means (25, 26, 27) lengthways of which the exchangeable printed boards (18, 29, 30) are displaceable and pluggable by their female connectors (31) in the direction of displacement, are provided at the bottom (3) of the lower housing part (1).

2. Unit according to claim 1,
characterised by the fact that the exchangeable printed boards (28, 29, 30) are of different size.

3. Unit according to claim 1,
characterised by the fact that a shielding plate (35) is disposed at the housing bottom (3) which closely fits through resilient fingers (35a) to contacts of the exchangeable printed boards (28, 29, 30).

4. Unit according to claim 1,
characterised by the fact that the lower housing part (1) has walls (9, 10, 12) at opposing sides which form lateral cable ducts (13).

5. Unit according to claim 4,
characterised by the fact that two of said walls (9, 10) serve simultaneously for the mounting of the upper printed board (16).

6. Unit according to claim 1,
characterised by the fact that additional peripheral modules (21, 22), for example a display module, are provided which are pluggable onto the upper printed board (16).

7. Unit according to claim 1,
characterised by the fact that light conductors (38) are disposed in the housing cover (2) being in contact with light sources (39) provided on the printed boards (16, 28, 29, 30).

8. Unit according to claim 7,
characterised in that the light sources are light emitting diodes (39).

## Revendications

1. Unité de commande programmable comprenant un boîtier en matière synthétique avec une partie inférieure (1) et un couvercle (2) fixé de manière amovible à la partie inférieure (1), et
une pluralité de cartes à circuits imprimés (14, 16, 28, 29, 30) disposées de manière accessible dans la partie inférieure (1) dans au moins deux plans superposés,
caractérisée en ce qu'une carte à circuits imprimés supérieure (16) est disposée à titre de carte principale, comportant une unité centrale (CPU), de manière fixe dans un plan supérieur,
qu'une carte bus à circuits imprimés (14) comportant deux rangées de connecteurs mâles (32) est disposée de manière fixe dans un plan inférieur,
que des cartes à circuits imprimés interchangeables (28, 29, 30), agencées comme modules périphériques et comportant des connecteurs femelles (31) coordonnés aux conducteurs mâles (32), sont prévus pouvant être insérées entre la carte à circuits imprimés supérieure (16) et le fond (3) de la partie inférieure (1) du boîtier et raccordées à la carte bus à circuits imprimés (14) de sorte que toutes ces cartes à circuits imprimés interchangeables (28, 29, 30) sont situées dans le plan inférieur, et
que des guides (25, 26, 27) sont disposés au fond (3) de la partie inférieure (1) du boîtier le long desquels les cartes à circuits imprimés interchangeables (28, 29, 30) peuvent être déplacées et enfichées dans le sens du déplacement par leurs connecteurs femelles (31).

2. Unité selon la revendication 1,
caractérisée en ce que les cartes à circuits imprimés interchangeables (28, 29, 30) sont de grandeur différente.

3. Unité selon la revendication 1,
caractérisée en ce qu'une tôle de blindage (35) est disposée au fond (3) du boîtier portant par des doigts élastiques (35a) sur des contacts des cartes à circuits imprimés interchangeables (28, 29, 30).

4. Unité selon la revendication 1,
caractérisée en ce que la partie inférieure (1) du boîtier comporte des parois (9, 10, 12) sur ses côtés opposés formant des caniveaux de câbles latéraux.

5. Unité selon la revendication 4,
caractérisée en ce que deux de ces parois (9, 10) servent en même temps pour le montage de la carte à circuits imprimés supérieure (16).

6. Unité selon la revendication 1,
caractérisée en ce que des modules périphériques additionnels (21, 22), par exemple un module d'affichage, sont prévus pouvant être enfichés sur la carte à circuits imprimés supérieure (16).

7. Unité selon la revendication 1,
caractérisée en ce que des conducteurs de lumière (38) sont disposés dans le couvercle (2) du boîtier qui sont en contact avec des sources de lumière (39) agencées sur les cartes à circuits imprimés (16, 28, 29, 30).

8. Unité selon la revendication 7,
caractérisée en ce que les sources de lumière sont des diodes électroluminescentes (39).
